(19) Europäisches Patentamt / European Patent Office / Office européen des brevets

(11) **EP 4 391 362 A1**

(12) **DEMANDE DE BREVET EUROPEEN**

(43) Date de publication:
26.06.2024 Bulletin 2024/26

(21) Numéro de dépôt: 23217917.6

(22) Date de dépôt: **19.12.2023**

(51) Classification Internationale des Brevets (IPC):
*H02S 40/30* (2014.01)

(52) Classification Coopérative des Brevets (CPC):
**H02S 40/30; H01M 14/00**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **20.12.2022 FR 2213992**

(71) Demandeur: **Commissariat à l'énergie atomique et aux énergies alternatives**
**75015 Paris (FR)**

(72) Inventeur: **VERVAART, Mark**
**38054 GRENOBLE CEDEX 9 (FR)**

(74) Mandataire: **Lavoix**
**2, place d'Estienne d'Orves**
**75441 Paris Cedex 09 (FR)**

(54) **CIRCUIT DE CONTRÔLE D'UN MICROCONTRÔLEUR D'UN SYSTÈME PHOTOVOLTAÏQUE SANS BATTERIE, DISPOSITIFS ET PROCÉDÉ ASSOCIÉS**

(57) La présente invention concerne un circuit de contrôle (16) d'un contrôleur d'un système photovoltaïque, le circuit de contrôle (16) comportant :
- une entrée (16E),
- une sortie (16S),
- une unité de démarrage formée par un circuit de dissipation (22) de la puissance, un circuit de régulation (24) en tension et un comparateur (26),
- un premier commutateur (18) présentant une position dans laquelle l'unité de démarrage est connectée à l'entrée (16E) et une position inverse, et
- un deuxième commutateur (20) présentant une position dans laquelle l'entrée (16E) et la sortie (16S) ne sont pas reliées et une position inverse,
le comparateur (26) comparant les tensions du circuit de dissipation (22) et du circuit de régulation (24), le comparateur (26) émettant une tension de commande des deux commutateurs (18, 20) dépendant de la comparaison.

FIG.2

EP 4 391 362 A1

## Description

La présente invention concerne un circuit de contrôle d'un microcontrôleur d'un système photovoltaïque comprenant un module photovoltaïque. La présente invention se rapporte également à un ensemble comprenant un tel circuit de contrôle et un microcontrôleur et à un système photovoltaïque comprenant ces éléments. La présente invention concerne aussi un procédé de contrôle d'un microcontrôleur utilisant un tel circuit de contrôle.

Du fait du réchauffement climatique, il est souhaitable de développer les énergies dites « renouvelables ». Parmi celles-ci, l'énergie solaire est particulièrement intéressante.

Une manière d'en bénéficier est d'utiliser un module photovoltaïque qui est adapté pour convertir de l'énergie issue des photons générés par le soleil en énergie électrique. Pour cela, le module photovoltaïque comporte un ensemble de cellules photovoltaïques reliées entre elles électriquement. Ces cellules effectuent la conversion photoélectrique. Cela permet ainsi au module photovoltaïque de fonctionner comme un générateur électrique de courant continu en présence de rayonnement solaire.

Or, pour exploiter ce courant généré dans une utilisation spécifique, il convient également de prendre en compte le fait que cette utilisation nécessite une tension comprise entre une tension minimale et une tension maximale.

Aussi, il est connu d'utiliser également une batterie dont le rôle est double : d'une part servir de réservoir pour l'énergie produite par le module photovoltaïque et d'autre part servir de source de tension pour l'utilisation souhaitée.

L'ensemble du module photovoltaïque et de la batterie forme ainsi un système photovoltaïque autonome au sens où le système n'est pas couplé au réseau électrique.

Toutefois, la durée de vie d'un tel système photovoltaïque est, en pratique, limitée par la durée de vie de la batterie.

Pour cela, il suffirait donc de se passer d'une batterie mais en début de journée, quand l'irradiance est très faible, un phénomène de démarrage et arrêt a lieu.

En effet, pendant la nuit, la puissance fournie par le module photovoltaïque est nulle, et au tout début de la journée, il y a une période durant laquelle il n'y a pas encore assez de l'énergie pour bien mettre en route le système comportant le module photovoltaïque.

De fait, dès qu'un rayon de lumière atteint le module photovoltaïque, celui-ci génère rapidement une tension plus élevée que la tension de démarrage.

Toutefois, cette tentative de démarrage se solde par un échec car le courant produit est encore insuffisant. Ce phénomène se répète jusqu'à ce que le courant produit soit suffisant.

Il existe donc un besoin pour un système photovoltaïque pouvant fonctionner sans l'utilisation d'une batterie.

A cet effet, la description décrit un circuit de contrôle d'un contrôleur d'un système photovoltaïque comprenant un module photovoltaïque, le circuit de contrôle comportant :

- une entrée propre à être connectée au module photovoltaïque,
- une sortie propre à être connectée au contrôleur,
- un circuit de dissipation de la puissance reçue sur l'entrée du circuit de contrôle,
- un circuit de régulation de la tension reçue sur l'entrée du circuit de contrôle,
- un comparateur, l'ensemble du circuit de dissipation, du circuit de régulation et du comparateur formant une unité de démarrage,
- un premier commutateur présentant une première position dans laquelle l'unité de démarrage est connectée à l'entrée du circuit de contrôle et une deuxième position dans laquelle l'unité de démarrage n'est pas connectée à l'entrée du circuit de contrôle, la position du premier commutateur étant commandable par une tension de commande, et
- un deuxième commutateur présentant une première position dans laquelle l'entrée et la sortie du circuit de contrôle ne sont pas reliées et une deuxième position dans laquelle l'entrée et la sortie du circuit de contrôle sont reliées, la position du deuxième commutateur étant commandable par une tension de commande,

le comparateur étant propre à comparer la tension en un point du circuit de dissipation avec la tension en un point du circuit de régulation de tension, chacun des points utilisés par le comparateur étant appelé point de comparaison, le comparateur étant propre à émettre en sortie une tension de commande des deux commutateurs dépendant de la comparaison entre la valeur des tensions des deux points de comparaison.

Selon des modes de réalisation particuliers, le circuit de contrôle présente une ou plusieurs des caractéristiques suivantes, prise(s) isolément ou selon toutes les combinaisons techniquement possibles :

- lorsque la tension en un point du circuit de régulation de tension est inférieure à la tension en un point du circuit de dissipation, le comparateur est propre à émettre une tension de commande imposant que la position du deuxième commutateur soit la deuxième position.
- lorsque la tension en un point du circuit de régulation de tension est inférieure à la tension en un point du circuit de dissipation, le comparateur est propre à émettre une tension de commande imposant que la position du premier commutateur soit la deuxième position.
- le circuit de dissipation est un pont présentant au moins deux composants et un point milieu, le point de comparaison du circuit de dissipation étant le point milieu.

- les composants du circuit de dissipation sont en série.

- les composants du circuit de dissipation sont deux résistances de même valeur.

- le circuit de régulation est propre à assurer que la tension au point de comparaison du circuit de régulation soit égale à la tension reçue en entrée jusqu'à une tension seuil, la tension au point de comparaison du circuit de régulation étant égale à la tension seuil pour une tension reçue en entrée supérieure au seuil.

- le circuit de régulation est un pont présentant au moins deux composants et un point milieu, le point de comparaison du circuit de régulation étant le point milieu du circuit de régulation.

- le circuit de régulation comporte un composant régulateur de tension.

- le composant régulateur de tension est une diode Zener.

- le circuit de régulation est formée par une résistance et une diode Zener en série, la diode Zener ayant une cathode reliée au point milieu du circuit de régulation.

- la diode Zener présente une tension Zener, le comparateur étant alimenté par une tension d'alimentation égale à deux fois la tension Zener.

La description se rapporte également à un ensemble comportant :

- un contrôleur d'un système photovoltaïque comprenant un module photovoltaïque, et

- un circuit de contrôle tel que précédemment décrit, le contrôleur étant relié à la sortie du circuit de contrôle.

La description décrit aussi un système photovoltaïque comprenant :

- un module photovoltaïque,
- un contrôleur, et
- un circuit de contrôle tel que précédemment décrit, l'entrée du circuit de contrôle étant reliée au module photovoltaïque et la sortie du circuit de contrôle étant reliée au contrôleur.

Dans la présente description, l'expression « propre à » signifie indifféremment « adapté pour », « adapté à » ou « configuré pour ».

Des caractéristiques et avantages de l'invention apparaîtront à la lecture de la description qui va suivre, donnée uniquement à titre d'exemple non limitatif, et faite en référence aux dessins annexés, sur lesquels :

- la figure 1 est un schéma-bloc d'un exemple de système photovoltaïque comprenant notamment un contrôleur et un circuit de contrôle de ce contrôleur, et

- la figure 2 est une représentation schématique du circuit de contrôle de la figure 1. Un système photovoltaïque 10 est représenté schématiquement sur la figure 1.

Le système photovoltaïque 10 est ici un système propre à convertir de l'énergie solaire incidente en énergie électrique utilisable dans une utilisation prédéfinie.

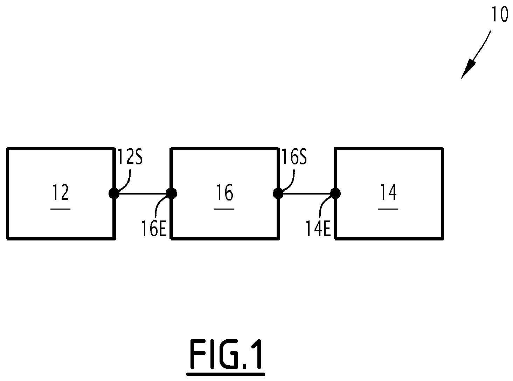

Pour cela, comme visible sur la figure 1, le système photovoltaïque 10 comporte un ensemble d'éléments parmi lesquels un module photovoltaïque 12 et un contrôleur 14.

Le module photovoltaïque 12 réalise la conversion de l'énergie lumineuse en énergie électrique. Pour cela, le module photovoltaïque 12 rassemble un ensemble de cellules photovoltaïques.

Le module photovoltaïque 12 est propre à délivrer un courant en sortie qui est proportionnel à l'irradiance de la lumière reçue par le module photovoltaïque 12.

Une tension est également générée sur la sortie du module photovoltaïque 12, cette tension variant en fonction de l'irradiance. Cette tension de sortie du module photovoltaïque 12 est notée $V_{mod}$ dans la suite de la description.

Le contrôleur 14 sert à contrôler les différents éléments électroniques du système photovoltaïque 10.

Parmi ces éléments électroniques, il peut être cité, à titre d'exemple, le système de supervision, le système décidant à partir de quel moment on passe en mode de production d'électricité par le module photovoltaïque 12 ou des composants permettant l'injection sur le réseau de l'électricité produite par le module photovoltaïque.

Le contrôleur 14 est ici un microcontrôleur 14.

A ce titre, le contrôleur 14 a besoin d'une puissance de fonctionnement relativement faible pour fonctionner correctement.

Selon un exemple typique non limitatif, le contrôleur 14 consomme une tension de 5 V pour un courant de 20 mA.

Le système photovoltaïque 10 comporte également un circuit de contrôle 16 du contrôleur 14.

Le circuit de contrôle 16 est intercalé entre le module photovoltaïque 12 et le contrôleur 14.

Cela signifie que le circuit de contrôle 16 présente une entrée 16E et une sortie 16S, l'entrée 16E du circuit de contrôle 16 étant reliée au module photovoltaïque 12 (plus précisément à sa sortie 12S) et la sortie 16S du circuit de contrôle 16 étant reliée au contrôleur 14.

Comme son nom l'indique, le circuit de contrôle 16 sert à contrôler le contrôleur 14 et plus précisément à contrôler les moments où il doit fonctionner.

Le circuit de contrôle 16 sert, en particulier, de circuit de démarrage du contrôleur 14.

Dans le contexte décrit, le circuit de contrôle 16 est ainsi propre à détecter une irradiance très faible, à déterminer si cette irradiance respecte une condition prédéfinie et à déclencher le démarrage du contrôleur 14 lorsque la condition prédéfinie est remplie.

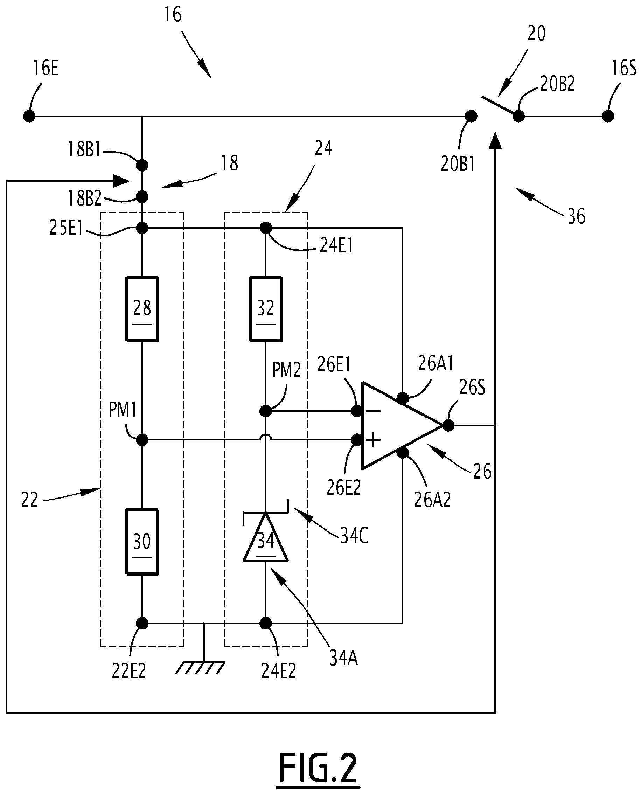

Le circuit de contrôle 16 est représenté plus précisément sur la figure 2.

Le circuit de contrôle 16 comporte un premier commutateur 18, un deuxième commutateur 20, un premier pont 22, un deuxième pont 24 et un comparateur 26.

Chaque commutateur 18 (respectivement 20) présente deux bornes 18B1 et 18B2 (respectivement 20B1 et 20B2), une borne 18B1 (respectivement 20B1) étant reliée à l'entrée 16E du circuit de contrôle 16 et donc présentant un potentiel égal à la tension de sortie $V_{mod}$ du module photovoltaïque 12.

L'autre borne 18B2 du premier commutateur 18 est reliée aux deux ponts 22 et 24 alors que celle du deuxième commutateur 20 est reliée à la sortie 16S du circuit de contrôle 16 et ainsi à l'entrée 14E du contrôleur 14.

Selon l'exemple décrit, chaque commutateur 18 et 20 est un interrupteur commandable.

Chaque commutateur 18 et 20 présente deux positions, une position ouverte dans laquelle ses deux bornes 18B1 et 18B2 (respectivement 20B1 et 20B2) ne sont pas reliées et une position fermée dans laquelle ses deux bornes 18B1 et 18B2 (respectivement 20B1 et 20B2) sont reliées.

La position de chaque commutateur 18 ou 20 dépend de la tension appliquée sur le commutateur 18 ou 20.

En l'occurrence, il apparaîtra ultérieurement que la tension appliquée aux commutateurs 18 et 20 est la même, puisqu'elle provient du comparateur 26. Le comparateur 26 est ainsi propre à commander simultanément la position des deux commutateurs 18 et 20.

Le premier commutateur 18 est, en outre, inverse au sens où la position par défaut est la position dans laquelle l'entrée 16E du circuit de contrôle 16 est reliée au circuit de dissipation 22.

Le premier pont 22 comporte deux composants 28 et 30 en série, deux extrémités 22E1 et 22E2 et un point milieu PM1.

Le deuxième pont 24 comporte deux composants 32 et 34 en série, deux extrémités 24E1 et 24E2 et un point milieu PM2.

La première extrémité 22E1 ou 24E1 de chaque pont 22 ou 24 est reliée au premier commutateur 18 et ainsi connectée à l'entrée 16E du circuit de contrôle 16. La première extrémité 22E1 ou 24E1 de chaque pont 22 ou 24 est, de ce fait, à un potentiel égal à la tension de sortie $V_{mod}$ du module photovoltaïque 12.

La deuxième extrémité 22E2 ou 24E2 de chaque pont 22 ou 24 est reliée à la masse.

La tension entre les extrémités 22E1 et 22E2 (respectivement 24E1 et 24E2) de chaque pont 22 ou 24 est la tension de sortie $V_{mod}$ du module photovoltaïque 12.

Du fait des branchements précités, les deux ponts 22 et 24 sont dans une configuration parallèle.

Dans le cas du premier pont 22, les deux composants 28 et 30 sont chacun une résistance.

La résistance 28 du premier pont 22 dont les bornes sont reliées d'une part à la première extrémité 22E1 du premier pont 22 et d'autre part au point milieu PM1 est appelée dans la suite de la description « première résistance 28 ». La valeur de la première résistance 28 est notée R1.

L'autre résistance 30 dont les bornes sont reliées d'une part à la deuxième extrémité et d'autre part au point milieu est appelée dans la suite de la description « deuxième résistance 30 ». La valeur de la deuxième résistance 30 est notée R2.

Du fait de cette configuration, le premier pont 22 forme un diviseur de tension.

Cela implique que la tension du point milieu PM1 du premier pont 22 est égale au produit de la tension entre les extrémités 22E1 et 22E2 du premier pont 22 avec le rapport entre la valeur R2 de la deuxième résistance 30 et la somme de la valeur R1 de la première résistance 28 et de la valeur R2 de la deuxième résistance 30.

Comme la tension aux bornes du premier pont 22 est la tension de sortie $V_{mod}$ du module photovoltaïque 12, il vient :

$$V_{PM1} = \frac{R2}{R1 + R2} V_{mod}$$

Où $V_{PM1}$ est la tension du point milieu PM1 du premier pont 22.

Dans le cas du deuxième pont 24, les deux composants 32 et 34 sont une résistance et une diode Zener.

La résistance 32 du deuxième pont 24 dont les bornes sont reliées d'une part à la première extrémité 24E1 et d'autre part au point milieu PM2 est appelée dans la suite de la description « troisième résistance 32 ». La valeur de la troisième résistance 32 est notée R3.

La diode Zener 34 présente une anode 34A et une cathode 34C.

Une diode Zener est un composant semi-conducteur qui a la particularité, contrairement aux diodes conventionnelles, de pouvoir laisser passer le courant dans les deux sens sous certaines conditions.

Dans le sens de circulation anode-cathode, une diode Zener 34 se comporte comme une diode classique. La tension de seuil associée est usuellement de l'ordre de 0,6 V.

Dans le sens inverse (cathode vers anode), le courant ne circule qu'à partir du moment où la valeur de tension aux bornes de la diode Zener 34 (dans ce cas, la tension inverse) a atteint un seuil limite. Cet effet est souvent appelé effet d'avalanche.

La tension inverse correspondant au seuil limite est appelée tension de claquage ou tension Zener $V_{Zener}$. La technologique actuelle donne accès à des tensions Zener $V_{Zener}$ variant beaucoup selon la diode Zener considérée, des valeurs comprises entre 1,2 V et plusieurs centaines de Volts pouvant être obtenues.

L'anode 34A est reliée à la deuxième extrémité 24E2 du deuxième pont 14 tandis que la cathode 34C est reliée au point milieu PM2 du deuxième pont 24.

La diode Zener 34 est donc ici connectée en inverse, ce qui confère à la diode Zener un rôle de régulateur de tension.

Cela implique que la diode Zener 34 devient conductrice lorsque la tension à ses bornes 34C et 34A atteint la tension Zener $V_{Zener}$. Lorsque la tension appliquée à ses bornes 34C et 34A dépasse la tension Zener $V_{Zener}$, la diode Zener 34 maintient la tension à ses bornes 34C et 34A à la valeur de la tension Zener $V_{Zener}$.

Le comparateur 26 comporte des bornes d'alimentation 26A1 et 26A2 deux entrées et une sortie 28S.

Le comparateur 26 est un composant actif alimenté par la tension appliquée sur ses bornes d'alimentation 26A1 et 26A2.

La première borne d'alimentation 26A1 est connectée à la sortie du module photovoltaïque 12 via le premier commutateur 18 et la deuxième borne d'alimentation 26A2 est reliée à la masse.

La tension d'alimentation aux bornes du comparateur 26 est donc la tension de sortie $V_{mod}$ du module photovoltaïque 12,

Le comparateur 26 a pour rôle de comparer la différence de potentiel entre ses deux entrées 26E1 et 26E2.

La première entrée 26E1 du comparateur 26 est notée par un signe « - » sur la figure 2 tandis que la deuxième entrée 26E2 du comparateur 26 est notée par un signe « + » sur la figure 2. De ce fait, la valeur de la tension sur la première entrée 26E1 du comparateur 26, respectivement sur la deuxième entrée 26E2 du comparateur 26, est notée V-, respectivement V+.

Le comparateur 26 est propre à effectuer une comparaison entre la valeur V- de la tension sur la première entrée 26E1 et la valeur V+ de la tension sur la deuxième entrée 26E2 et à émettre en sortie un signal dépendant du signe de la différence entre la valeur V- de la tension sur la première entrée 26E1 et la valeur V+ de la tension sur la deuxième entrée 26E2.

La sortie du comparateur 26 prend ainsi deux valeurs de tension, une première valeur correspondant à une différence négative et une deuxième valeur correspondant à une différence positive.

Plus précisément, lorsque la valeur V- de la tension sur la première entrée 26E1 est supérieure à la valeur V+ de la tension sur la deuxième entrée 26E2, la sortie du comparateur 26 est à la première valeur, cette première valeur étant une tension nulle, ce qui correspond au 'lever du soleil'.

Réciproquement, lorsque la valeur V- de la tension sur la première entrée 26E1 est inférieure ou égale à la tension sur la valeur V+ de la tension sur la deuxième entrée 26E2, la sortie est à la deuxième valeur, cette deuxième valeur étant la tension d'alimentation, c'est-à-dire la tension de sortie $V_{mod}$ du module photovoltaïque 12.

Comme l'indique schématiquement la flèche 36 sur la figure 2, la tension en sortie du comparateur 26 permet de commander la position du deuxième commutateur 20.

Ainsi, lorsque la sortie du comparateur 26 est à la première valeur (tension nulle), le deuxième commutateur 20 se met ou est dans la position ouverte alors que, lorsque la sortie du comparateur 26 est à la deuxième valeur ($V_{mod}$), le deuxième commutateur 20 se met ou est dans la position fermée.

La position du deuxième commutateur 20 dépend ainsi de la comparaison entre la valeur V- de la tension sur la première entrée 26E1 et la valeur V+ de la tension sur la deuxième entrée 26E2.

Dans le montage de la figure 2, la deuxième entrée 26E2 est reliée au point milieu du premier pont 22 et la première entrée 26E1 est reliée au point milieu du deuxième pont 24.

Le comparateur 26 effectue ainsi une comparaison entre la valeur $\frac{R2}{R1+R2} V_{mod}$ et la tension aux bornes de la diode Zener.

Le fonctionnement du circuit de contrôle 16 est maintenant décrit en référence à un démarrage du contrôleur 14 lors du lever du soleil le matin.

Le but est de s'assurer que le contrôleur 14 démarre lorsque suffisamment de soleil illumine le module photovoltaïque 12 pour éviter un phénomène de démarrage et arrêt.

En effet, puisque la nuit, la puissance fournie par le module photovoltaïque 12 est nulle, au tout début de la journée, il y a une période durant laquelle il n'y a pas encore assez de l'énergie pour bien mettre en route le contrôleur 14.

Cela provient notamment du fait qu'aux premières lumières du jour, une cellule photovoltaïque génère rapidement une tension plus élevée que la tension de démarrage du contrôleur 14, de sorte qu'il essaie de démarrer. Mais, le courant produit est alors négligeable, de sorte que le contrôleur 14 n'arrive pas à démarrer et ainsi de suite jusqu'à ce que le courant produit soit suffisant.

Un tel démarrage peut endommager le contrôleur 14.

Aussi, il pourra être choisi que le contrôleur 14 ne sera démarré que lorsqu'une certaine puissance est disponible.

Dans l'exemple décrit, le seuil de puissance se décline selon une valeur limite de courant à délivrer et une valeur limite de tension.

Autrement formulé, il est utilisé un seuil de démarrage en tension et un seuil de démarrage en courant.

Pour obtenir ces valeurs, compte-tenu des valeurs typiques mentionnées précédemment (tension de 5 V pour un courant de 20 mA), il est utile de prendre une marge, cette marge dépendant du cas de figure.

Par exemple, il est ici choisi une valeur de tension de 10 V et un courant de 50 mA. Cela signifie que le circuit de contrôle 16 cherche ici à démarrer le contrôleur 14 uniquement lorsque la tension et le courant fournis par le module photovoltaïque 12 sont respectivement au seuil de démarrage en tension (10 V) et au seuil de démarrage en courant (50 mA).

Pour expliquer comment le circuit de contrôle 16 réalise cette fonction, il convient de rappeler que la tension de comparaison avec la tension V- sur la première entrée 26E1 du comparateur 26 est en permanence $\frac{R2}{R1+R2}V_{mod}$.

La tension appliquée aux bornes de la diode Zener est ici la tension de sortie du module photovoltaïque 12 $V_{mod}$ mais la valeur V- de la tension sur la première entrée 26E1 du comparateur 26 va dépendre du régime de fonctionnement de la diode Zener.

Lorsque la tension aux bornes de la diode Zener est inférieure à la tension Zener $V_{Zener}$, la diode Zener bloque le courant et la tension aux bornes de la diode Zener suit tension de sortie du module photovoltaïque 12 $V_{mod}$.

Cela signifie que $V- = V_{mod}$ dans ce régime.

De ce fait, dans ce régime, la tension aux bornes de la diode Zener est en permanence plus élevée que la tension de comparaison $\frac{R2}{R1+R2}V_{mod}$.

Ainsi, le comparateur 26 sort en sortie la première valeur (tension nulle) et le deuxième commutateur 20 est en position ouverte.

Lorsque la tension aux bornes de la diode Zener est supérieure à la tension Zener $V_{Zener}$, la diode Zener laisse passer le courant et la tension aux bornes de la diode Zener ne suit alors plus la tension du module mais reste à la ttension Zener $V_{Zener}$.

Cela implique que la valeur V- de la tension sur la première entrée 26E1 reste fixée à la tension Zener $V_{Zener}$. En parallèle, la tension de comparaison est toujours $\frac{R2}{R1+R2}V_{mod}$.

Ainsi, lorsque la tension du module dépasse la tension Zener $V_{Zener}$, le comparateur 26 compare la valeur de la tension Zener $V_{Zener}$ à la valeur $\frac{R2}{R1+R2}V_{mod}$.

Lorsque la valeur $\frac{R2}{R1+R2}V_{mod}$ est inférieure à $V_{Zener}$, le comparateur 26 sort en sortie la première valeur (tension nulle) et le deuxième commutateur 20 est (ou se met) en position ouverte alors que, lorsque la valeur $\frac{R2}{R1+R2}V_{mod}$ est supérieure à $V_{Zener}$, le comparateur 26 sort en sortie la deuxième valeur ($V_{mod}$) et le deuxième commutateur 20 est (ou se met) en position fermée.

Il existe ainsi trois régimes de fonctionnement qui sont brièvement repris ici.

Lorsque la tension du module $V_{mod}$ est comprise entre 0 et la tension Zener $V_{Zener}$, la diode Zener est dans un état bloqué et le comparateur 26 sort en sortie la première valeur (tension nulle).

Lorsque la tension du module $V_{mod}$ est comprise entre la tension Zener $V_{Zener}$ et $\frac{R1+R2}{R2}V_{Zener}$, un effet d'avalanche a lieu dans la diode Zener mais le comparateur 26 sort toujours en sortie la première valeur.

Lorsque la tension du module $V_{mod}$ est supérieure ou égale $\frac{R1+R2}{R2}V_{Zener}$, un effet d'avalanche a toujours lieu dans la diode Zener mais le comparateur 26 sort en sortie la deuxième valeur $V_{mod}$).

Pour prendre un exemple numérique, Il est supposé que la tension Zener $V_{Zener}$ est égale à 5V et que les valeurs de résistances de la première résistance 28 et de la deuxième résistance 30 sont égales (R1 = R2).

Pour un fonctionnement optimal du comparateur 26, il sera aussi utilisé pour la tension d'alimentation du comparateur 26 égale à deux fois la tension Zener $V_{Zener}$, c'est-à-dire 10 V ici.

Les trois régimes précédents deviennent alors les suivants.

Lorsque la tension du module est comprise entre 0 et 5 V, la diode Zener est dans un état bloqué et le comparateur 26 sort en sortie la première valeur (tension nulle).

Lorsque la tension du module est comprise entre 5 V et 10 V, un effet d'avalanche a lieu dans la diode Zener mais le comparateur 26 sort toujours en sortie la première valeur.

Lorsque la tension du module est supérieure ou égale 10 V, en présence d'un effet d'avalanche, le comparateur 26 sort en sortie la deuxième valeur ($V_{mod}$).

Du point de vue du deuxième commutateur 20 ou de la sortie du comparateur 26, il existe uniquement deux régimes : un premier régime dans lequel la tension du module est inférieure à 10 V avec le deuxième commutateur 20 dans la position ouverte et un deuxième régime dans lequel la tension du module est supérieure ou égale à 10 V avec le deuxième commutateur 20 dans la position fermée.

Plus généralement, si on s'abstrait des valeurs numériques particulières précitées, le circuit de contrôle 16 fonctionne selon un premier régime dans lequel la tension du module est inférieure à $\frac{R1+R2}{R2}V_{Zener}$ avec le deuxième commutateur 20 dans la position ouverte et un deuxième régime dans lequel la tension du module est supérieure ou égale à $\frac{R1+R2}{R2}V_{Zener}$ avec le deuxième commutateur 20 dans la position fermée.

C'est donc uniquement les valeurs de la tension Zener $V_{Zener}$, de la valeur R1 première résistance 28 et de la valeur R2 de la deuxième résistance 30 qui viennent fixer le seuil à partir duquel le deuxième commutateur 20 bascule de la position ouverte à la position fermée.

De ce fait, pour obtenir un seuil de démarrage en tension $V_{seuil}$ fixée, cela implique que les valeurs R1 et R2 de la première résistance 28 R1 et de la deuxième résistance 30 R2 et de la tension Zener $V_{Zener}$ soient choisies pour qu'il y a une relation d'égalité $\frac{R1+R2}{R2}V_{Zener} = V_{seuil}$.

Avec la valeur de R1 = R2 et de $V_{Zener}$ = 5V, il est bien obtenu un seuil de démarrage en tension de 10 V.

Quant à l'intensité fournie lorsque la tension dépasse le seuil de démarrage en tension $V_{seuil}$, elle est donnée par la valeur du courant circulant dans le premier pont 22.

Plus précisément, cette intensité est, d'après la loi d'Ohm, le rapport entre la tension appliquée aux bornes du premier pont 22 avec la résistance totale du premier pont 22. Cela s'écrit mathématiquement ainsi :

$$I_{mod} = \frac{V_{mod}}{R1 + R2}$$

Cela implique qu'il est souhaité au seuil que la relation suivante soit vérifiée par le seuil de démarrage en courant $I_{seuil}$ :

$$I_{seuil} = \frac{V_{seuil}}{R1 + R2}$$

Dans l'exemple numérique décrit, cela signifie que la valeur de la première résistance 28 et de la deuxième résistance 30 soit égale à 100 Ω pour garantir que le courant ait une valeur de 50 mA.

Cela signifie que le circuit de contrôle 16 assure que le module photovoltaïque 12 délivre à la fois une tension correspondant au seuil de démarrage en tension $V_{seuil}$ et un courant correspondant au seuil de démarrage en courant $I_{seuil}$.

Formulé du point de vue du rayonnement lumineux, cela signifie que le circuit de contrôle 16 est capable de déterminer l'irradiance minimale que doit recevoir le module photovoltaïque 12 pour respecter les critères en tension et en courant, c'est-à-dire la puissance minimale pour alimenter le contrôleur 14.

Le circuit de contrôle 16 sert ainsi de détecteur de puissance pour démarrer le contrôleur 14.

La puissance inférieure au seuil de puissance souhaitée est dissipée dans la première résistance 28 et la deuxième résistance 30.

En même temps que le contrôleur 14 démarre, cette dissipation de puissance doit cesser.

Aussi, lorsque le contrôleur 14 démarre, le comparateur 26 contrôle également le premier commutateur 18 pour qu'il passe dans la position ouverte (la position qui n'est pas la position normale pour ce premier commutateur 18) et tandis que le deuxième commutateur 20 est en position fermée.

Cela permet de faire en sorte que l'ensemble des deux ponts et du comparateur 26 soient déconnectés de l'entrée du circuit de contrôle 16.

En d'autre terme, l'ensemble des deux ponts et du comparateur 26 n'est plus en liaison avec la sortie du module photovoltaïque 12.

Cet ensemble sert donc d'unité de démarrage et le premier commutateur 18 sert à connecter/déconnecter l'unité de démarrage.

L'unité de démarrage reste déconnectée toute la journée puisque l'ensoleillement permet au contrôleur 14 de fonctionner.

Avant le passage vers la nuit, le contrôleur 14 s'assure de se fermer proprement et remet le premier commutateur 18 dans la position fermée pour activer l'unité de démarrage.

Une temporisation de cette fermeture après l'extinction du contrôleur 14 peut être mise en place pour éviter un risque de redémarrage inopiné avant la nuit complète.

Il peut d'ailleurs être noté ici qu'après l'extinction du contrôleur 14, le deuxième commutateur 20 est dans la position correspondant à l'état ouvert.

Pour détecter le passage vers la nuit, le contrôleur 14 surveille la tension émise par le module photovoltaïque 12 par exemple par le biais d'une unité de détection de la tension du module photovoltaïque 12.

Le contrôleur 14 est ainsi propre à contrôler la position du premier commutateur 18 en fonction de la tension détectée.

Le circuit de contrôle 16 présente donc l'avantage de permettre de contrôler le contrôleur 14 et notamment d'assurer un bon démarrage de celui-ci.

Le circuit de contrôle 16 est, en outre, un circuit électronique très simple puisqu'il comporte uniquement trois résistance, une diode Zener et un comparateur 26.

Le système photovoltaïque 10 en résultant est ainsi adapté à fonctionner sans batterie.

Cela permet d'obtenir une meilleure durée de vie pour le système photovoltaïque 10.

Il est bien entendu possible d'imaginer des variantes du circuit de contrôle 16 de la figure 2 réalisant la même fonction.

A titre d'exemple, les deux résistances du premier pont 22 pourraient présenter des valeurs de résistances différentes.

Selon une variante, le premier pont 22 pourrait comporter plusieurs résistances en série, le point dit point milieu étant alors un point intermédiaire du premier pont 22 différent des deux extrémités (ici une des bornes de la résistance du milieu).

Il pourrait même être envisagé un premier pont 22 comportant des résistances en parallèle.

Dans chacun des cas, le premier pont 22 sert de circuit de dissipation de la puissance reçue sur l'entrée du circuit de contrôle 16 pendant la première partie de la matinée.

En ce qui concerne le deuxième pont 24, il pourrait être envisagé aussi d'utiliser des montages avec plus de résistances.

A la place de la diode Zener, un circuit plus complexe avec un montage de plusieurs diodes conventionnelles pourrait être envisagé, notamment pour disposer d'un seuil réglable.

Plus largement, tout composant ou circuit permettant de réguler la tension en un point du pont peut être considéré ici.

Dans chacun des cas, le premier pont 22 sert de circuit de régulation de la tension reçue sur l'entrée du circuit de contrôle 16, c'est-à-dire de circuit faisant en sorte que la tension en un point soit égale à la tension reçue en entrée jusqu'à une tension seuil, la tension à ce point étant égale à la tension seuil pour une tension reçue en entrée supérieure au seuil.

On comprendra des variantes précitées que le comparateur 26 n'effectue pas nécessairement la comparaison au point milieu mais bien en un point de comparaison faisant partie du circuit considéré.

Ainsi, dans tous les modes de réalisation décrits, le circuit de contrôle 16 comporte une unité de démarrage formée d'un circuit de dissipation, d'un circuit de régulation de la tension et d'un comparateur 26.

Le comparateur 26 est propre à comparer la tension en un point de comparaison du circuit de dissipation 22 avec la tension en un point de comparaison du circuit de régulation 24, le comparateur 26 étant propre à émettre en sortie une tension de commande des deux commutateurs 18 et 20 dépendant de la comparaison entre la valeur des tensions des deux points de comparaison.

**Revendications**

1. Circuit de contrôle (16) d'un contrôleur (14) d'un système photovoltaïque (10) comprenant un module photovoltaïque (12), le circuit de contrôle (16) comportant :

- une entrée (16E) propre à être connectée au module photovoltaïque (12),

- une sortie (16S) propre à être connectée au contrôleur (14),

- un circuit de dissipation (22) de la puissance reçue sur l'entrée (16E) du circuit de contrôle (16),

- un circuit de régulation (24) de la tension reçue sur l'entrée (16E) du circuit de contrôle (16),

- un comparateur (26), l'ensemble du circuit de dissipation (22), du circuit de régulation (24) et du comparateur (26) formant une unité de démarrage,

- un premier commutateur (18) présentant une première position dans laquelle l'unité de démarrage est connectée à l'entrée (16E) du circuit de contrôle (16) et une deuxième position dans laquelle l'unité de démarrage n'est pas connectée à l'entrée (16E) du circuit de contrôle (16), la position du premier commutateur (18) étant commandable par une tension de commande, et

- un deuxième commutateur (20) présentant une première position dans laquelle l'entrée (16E) et la sortie (16S) du circuit de contrôle (16) ne sont pas reliées et une deuxième position dans laquelle l'entrée (16E) et la sortie (16S) du circuit de contrôle (16) sont reliées, la position du deuxième commutateur (20) étant commandable par une tension de commande,

le comparateur (26) étant propre à comparer la tension en un point (PM1) du circuit de dissipation (22) avec la tension en un point (PM2) du circuit de régulation (24), chacun des points (PM1, PM2) utilisés par le comparateur (26) étant appelé point de comparaison (PM1, PM2), le comparateur (26) étant propre à émettre en sortie une tension de commande des deux commutateurs (18, 20) dépendant de la comparaison entre la valeur des tensions des deux points de comparaison (PM1, PM2),

le comparateur (26) étant propre à émettre une tension de commande imposant que la position du deuxième commutateur (20) soit la deuxième position lorsque la tension en un point (PM2) du circuit de régulation (24) de tension est inférieure à la tension en un point (PM1) du circuit de dissipation (22), et

le comparateur étant propre à émettre une tension de commande imposant que la position du premier commutateur (18) soit la deuxième position lorsque la tension en un point (PM2) du circuit de régulation (24) de tension est inférieure à la tension en un point (PM1) du circuit de dissipation (22).

2. Circuit de contrôle selon la revendication 1, dans lequel, le circuit de dissipation (22) est un pont présentant au moins deux composants (28, 30) et un point milieu (PM1), le point de comparaison du circuit de dissipation (22) étant le point milieu (PM1).

**3.** Circuit de contrôle selon la revendication 2, dans lequel les composants (28, 30) du circuit de dissipation (22) sont en série.

**4.** Circuit de contrôle selon la revendication 2 ou 3, dans lequel les composants (28, 30) du circuit de dissipation (22) sont deux résistances de même valeur.

**5.** Circuit de contrôle selon l'une quelconque des revendications 1 à 4, dans lequel le circuit de régulation (24) est propre à assurer que la tension au point de comparaison (PM2) du circuit de régulation (24) soit égale à la tension reçue en entrée jusqu'à une tension seuil, la tension au point de comparaison (PM2) du circuit de régulation (24) étant égale à la tension seuil pour une tension reçue en entrée supérieure au seuil.

**6.** Circuit de contrôle selon la revendication 5, dans lequel le circuit de régulation (24) est un pont présentant au moins deux composants (32, 34) et un point milieu (PM2), le point de comparaison du circuit de régulation (24) étant le point milieu (PM2) du circuit de régulation (24).

**7.** Circuit de contrôle selon l'une quelconque des revendications 1 à 6, dans lequel le circuit de régulation (24) comporte un composant régulateur de tension (34).

**8.** Circuit de contrôle selon la revendication 7, dans lequel le composant régulateur de tension (34) est une diode Zener.

**9.** Circuit de contrôle selon l'une quelconque des revendications 1 à 8, dans lequel le circuit de régulation (24) est formé par une résistance (32) et une diode Zener (34) en série, la diode Zener (34) ayant une cathode (34C) reliée au point milieu (PM2) du circuit de régulation (24).

**10.** Circuit de contrôle selon l'une quelconque des revendications 8 ou 9, dans lequel la diode Zener (34) présente une tension Zener, le comparateur (26) étant alimenté par une tension d'alimentation égale à deux fois la tension Zener.

**11.** Ensemble comportant :

- un contrôleur (14) d'un système photovoltaïque (10) comprenant un module photovoltaïque (12), et
- un circuit de contrôle (16) selon l'une quelconque des revendications 1 à 10, le contrôleur (14) étant relié à la sortie (16S) du circuit de contrôle (16).

**12.** Système photovoltaïque (10) comprenant :

- un module photovoltaïque (12),
- un contrôleur (14), et
- un circuit de contrôle (16) selon l'une quelconque des revendications 1 à 10, l'entrée (16E) du circuit de contrôle (16) étant reliée au module photovoltaïque (12) et la sortie du circuit de contrôle (16) étant reliée au contrôleur (14).

10

12S    16S

12    16    14

16E    14E

# FIG.1

## FIG.2

Europäisches
Patentamt

European
Patent Office

Office européen
des brevets

# RAPPORT DE RECHERCHE EUROPEENNE

Numéro de la demande

**EP 23 21 7917**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2010/322784 A1 (ARONSON N A; BACIGALUPO A J ET AL.) 23 décembre 2010 (2010-12-23) <br> * alinéas [0058] - [0065]; figures 4A,4C, 4D * <br> ----- | 1-12 | INV. <br> H02S40/30 |
| A | US 2018/281994 A1 (DE PAYREBRUNE MARK [CA]) 4 octobre 2018 (2018-10-04) <br> * alinéas [0059] - [0073]; figure 6A * <br> ----- | 1-12 | |
| A | FR 3 113 556 A1 (HELIOSENGI SARL [FR]) 4 mars 2022 (2022-03-04) <br> * alinéa [0024]; figure 2 * <br> ----- | 1-12 | |

**DOMAINES TECHNIQUES RECHERCHES (IPC)**

**H02S**

Le présent rapport a été établi pour toutes les revendications

| Lieu de la recherche | Date d'achèvement de la recherche | Examinateur |
|---|---|---|
| Munich | 11 avril 2024 | Lorenzo Feijoo, S |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
.......................................................................................
& : membre de la même famille, document correspondant

EPO FORM 1503 03.82 (P04C02)

**EP 4 391 362 A1**

## ANNEXE AU RAPPORT DE RECHERCHE EUROPEENNE
## RELATIF A LA DEMANDE DE BREVET EUROPEEN NO.

EP 23 21 7917

11-04-2024

| Document brevet cité au rapport de recherche | Date de publication | Membre(s) de la famille de brevet(s) | | Date de publication |
|---|---|---|---|---|
| US 2010322784 A1 | 23-12-2010 | US | 2010322784 A1 | 23-12-2010 |
| | | WO | 2010148137 A2 | 23-12-2010 |
| US 2018281994 A1 | 04-10-2018 | US | 2018281994 A1 | 04-10-2018 |
| | | WO | 2017177301 A1 | 19-10-2017 |
| FR 3113556 A1 | 04-03-2022 | AUCUN | | |

EPO FORM P0460